# EUROPÄISCHE PATENTSCHRIFT

(11) **EP 1 670 107 B1**
(45) Veröffentlichungstag und Bekanntmachung des Hinweises auf die Patenterteilung: **23.01.2008**
(21) Anmeldenummer: 05015307.1
(22) Anmeldetag: 14.07.2005
(51) Int. Cl.: H02B 1/30

(54) **Schaltschrank, Geräteschrank oder dergleichen Schrank mit einer elektrischen Leuchte**
Switch cabinet, equipment cabinet with electrical light
Armoire de distribution, pour équipement ou similaire et pourvue d'une lampe électrique

(30) Priorität: 07.12.2004 DE 202004018923 U
(43) Veröffentlichungstag der Anmeldung: 14.06.2006
(73) Patentinhaber: Hoffmeister Leuchten GmbH, 58507 Lüdenscheid (DE)
(72) Erfinder: Beukert, Thomas, 58507 Lüdenscheid (DE); Kleinhaus, Bodo, 44229 Dortmund (DE); Neubert, Jürgen, 30455 Hannover (DE)
(74) Vertreter: Köchling, Conrad-Joachim

(56) Entgegenhaltungen:
- EP-A- 0 178 598
- EP-A- 0 563 887
- EP-A- 0 725 458
- DE-U1- 9 304 479
- US-A- 2 694 137
- US-A- 5 072 343

## Beschreibung

Die Erfindung betrifft einen Schaltschrank, Geräteschrank oder dergleichen Schrank zur Aufnahme und Anordnung von elektronischen Bauteilen, wobei der Schaltschrank aus vertikalen und horizontalen metallischen Profilleisten sowie an den Profilleisten befestigten Verstrebungen, Wandteilen und dergleichen Stützteilen besteht, die Profilleisten aus zwei zueinander parallel angeordneten, Montagelochungen aufweisenden Profilabschnitten etwa rechteckiger Querschnittsform bestehen, die über einen Steg verbunden sind und zwischen sich einen seitlich offenen Hohlraum einschließen, und wobei in dem Schrank eine elektrische Leuchte mit Leuchtengehäuse, Leuchtmittel und elektrischen Funktions- und Anschlussteilen befestigt ist.

Derartige Schränke sind im Stand der Technik vielfach bekannt. Üblicherweise werden derartige Schränke mit Modulen beispielsweise zur Schaltung elektrischer Anlagen ausgestattet. Die Leuchten derartiger Schaltschränke befinden sich üblicherweise am Deckenbereich oder an der Tür des Schrankes.

Bei den aus dem Stand der Technik bekannten Lösungen ist es nachteilig, dass innerhalb des Schaltschrankes keine gleichmäßige Lichtverteilung, insbesondere bei in Reihen übereinander eingesetzten Modulen, gegeben ist. Sowohl zum Einbau weiterer Module als auch zur Kontrolle bestehender Schaltungen oder Leitungen ist aber eine gleichmäßige und ausreichende Lichtverteilung notwendig. Durch die in der Höhe aufeinander abgestimmten Module ist es mit den im Stand der Technik bekannten Lösungen nicht ohne weiteres möglich, die installierten Module oder Modulreihen auszuleuchten.

Aus der EP-A-0 563 887 ist eine Tragstruktur für Leuchtensysteme bekannt. Hierbei sind Profilteile mit X-förmigem Querschnitt vorgesehen, zwischen deren Profilschenkeln Fixier- und Aufnahmeräume für Beleuchtungssysteme und deren Komponenten vorgesehen sind.

Aus der US-A-5 072 343 ist ein Regalsystem bekannt, bei dem die lotrechten Regalsäulen als Profile mit Installationshohlräumen ausgebildet sind. Dabei sind in mindestens einem Profilhohlraum Leuchtstoffröhren angeordnet.

Aus der DE 93 04 479 U1 ist ein Möbel mit röhrenförmigen Leuchtkörpern bekannt, wobei in Säulen des Regalsystems Langfeldleuchten angeordnet sind.

Aus der EP-A-0 178 598 ist ein Bausatz für Möbelgestelle bekannt, wobei in Ausnehmungen von Vertikalsäulen Leuchten angeordnet sind.

Aus der EP-A-0 725 458 ist eine Profilschiene für Möbel bekannt, die auch eine Aufnahmenut zum Einsetzen eines Adapters aufweist, an den eine Leuchte anschließbar ist.

Der Erfindung liegt die Aufgabe zugrunde, einen Schaltschrank, Geräteschrank oder dergleichen Schrank zur Aufnahme und Anordnung von elektronischen Bauteilen zu schaffen, bei dem eine oder mehrere Leuchten vorgesehen sind, die bedarfsgemäß auch zwischen oder unter einem eingebauten Modul angeordnet werden kann, die dabei in ihrer Form ein Einsetzen weiterer und Herausnehmen bestehender Module ohne Einschränkung ermöglicht, und die schließlich erweiterbar auf eine beliebige Anzahl von Leuchten ist, bei der eine gleichmäßige und ausreichende Lichtverteilung insbesondere auch zwischen den Modulen gegeben ist. Zudem soll eine gute Wärmeabfuhr der vom Leuchtmittel der Leuchte erzeugten Wärme erreicht werden.

Zur Lösung dieser Aufgabe schlägt die Erfindung vor, dass das Gehäuse der Leuchte, dem von den Profilabschnitten gebildeten Hohlraum formmäßig angepasst ist, in den Hohlraum eingesetzt ist und an den Profilabschnitten befestigt ist, dass die den Hohlraum abschließende Vorderseite der Leuchte eine lichtdurchlässige Abdeckung aufweist, dass das Gehäuse der Leuchte im Querschnitt etwa dreieckig oder trapezförmig ist und zwei etwa rechtwinklig zueinander verlaufende Seitenflächen aufweist, die in der Montagesolllage an den Profilabschnitten anliegen, und dass das Gehäuse der Leuchte aus einem Wärme leitenden Material, beispielsweise aus Metall, besteht.

Eine derartige Leuchte kann schnell und einfach beispielsweise in Höhe der installierten Modulreihen an den Profilabschnitten des Schaltschrankes befestigt werden und ermöglicht somit eine Ausleuchtung des Raumes insbesondere auch im Bereich der Modulreihen. Auch kann eine derartige Leuchte schnell und einfach beispielsweise beim späteren Nachrüsten oder Einsetzen eines zusätzlichen Moduls von den Profilabschnitten entfernt werden und an einer anderen Stelle der Profilabschnitte befestigt werden.

Dabei ist eine besonders Platz sparende Anordnung der Leuchte erreicht.

Auch wird insbesondere das Anschließen oder Verkabeln der eingesetzten Module nicht durch die Leuchte gestört, da diese nicht räumlich in den Arbeitsbereich des Monteurs eingreift.

Die durch das Leuchtmittel entstehende Wärme der Leuchte wird durch ihr metallisches Gehäuse abgeleitet und auf die üblicherweise auch aus Metall bestehenden Profilabschnitte des Schaltschrankes übertragen. Somit ist ein Hitzestau innerhalb der Leuchte nahezu ausgeschlossen.

Zur schnellen und einfachen Befestigung der Leuchte an den Profilabschnitten und auch zur späteren eventuellen Demontage der Leuchte von den Profilabschnitten kann besonders bevorzugt vorgesehen sein, dass am Gehäuse der Leuchte Mittel zur Befestigung der Leuchte an den Profilabschnitten ausgebildet sind.

Als besonders schnelle und werkzeugfreie Befestigungsmöglichkeit kann bevorzugt vorgesehen sein, dass die Mittel zur Befestigung der Leuchte durch einen oder mehrere von den Seitenflächen des Gehäuses abragenden Haken oder Rastnasen gebildet sind, die in in den Profilabschnitten ausgebildete Montagelochungen, beispielsweise in Langlöcher, einsetzbar und in eine Haltelage verschiebbar sind.

Hierbei wird lediglich der abragende Haken der Leuchte in die Montagelochung des Profilabschnitts eingesteckt und in Längsrichtung des Profils in eine Haltelage verschoben. Dies geschieht schnell und einfach und insbesondere auch ohne den Einsatz eines Werkzeuges.

Ergänzend oder alternativ kann besonders bevorzugt vorgesehen sein, dass die Seitenflächen des Gehäuses der Leuchte Befestigungslochungen zum Durchführen von Schrauben aufweisen, mittels derer die Leuchte an der Profilleiste befestigbar ist.

Alternativ oder zusätzlich kann auch vorgesehen sein, dass das Gehäuse mittels Magneten an mindestens einem Profilabschnitt fixiert ist. Damit ist die Befestigung unabhängig vom Raster der Montagelochungen möglich.

Zur besonders Strom sparenden Beleuchtung des Schaltschrankes kann besonders bevorzugt vorgesehen sein, dass das Leuchtmittel der Leuchte durch mindestens eine, vorzugsweise durch mehrere in Längsrichtung der Leuchte verteilt angeordnete, LEDs gebildet ist.

Derartige LEDs haben den Vorteil, nur sehr wenig Wärme bei gleichzeitig geringem Stromverbrauch und hoher Lichtausbeute zu produzieren.

Zur Verstärkung der Leuchtstärke der LEDs kann besonders bevorzugt vorgesehen sein, dass zwischen den LEDs und dem Gehäuseboden je eine Reflektionsfläche angeordnet ist.

Dabei kann besonders bevorzugt vorgesehen sein, dass die den längsseitigen Gehäuseenden nahen Reflektionsflächen nahe den Enden des Gehäuses beginnend in einem spitzen Winkel zum Boden des Gehäuses angeordnet sind.

Durch eine derartige Anordnung von Reflektionsflächen wird eine besonders breite Ausstrahlung des austretenden Lichtes ermöglicht. Somit wird mit nur geringem Einsatz von Leuchtmitteln eine höchstmögliche Leuchtausbeute bewirkt.

Eine Lichtlenkung kann auch durch eine prismatische Ausbildung der transparenten Abdeckung oder eine prismatische Ausbildung in der Abdeckung erreicht werden.

Als alternatives Mittel zur Beleuchtung des Schaltschrankes kann besonders bevorzugt vorgesehen sein, dass das Leuchtmittel der Leuchte durch eine in dem Gehäuse längs angeordnete Leuchtstoffröhre gebildet ist.

Dabei kann besonders bevorzugt vorgesehen sein, dass als Leuchtstoffröhre eine T2 oder T5 Leuchtstoffröhre vorgesehen ist.

Eine derartige T2 oder T5 Leuchtstoffröhre kann aufgrund ihrer geringen Abmessungen besonders Platz sparend bei gleichzeitig hoher Lichtausbeute als Leuchtmittel verwendet werden.

Darüber hinaus kann besonders bevorzugt vorgesehen sein, dass Elektronikbauteile für die Leuchtstoffröhre in einem quaderförmigen Gehäuse angeordnet sind, welches im Gehäuse in Längsrichtung anschließend an die Leuchtstoffröhre oder hinter der Leuchtstoffröhre angeordnet ist.

Bei einer derartigen Anordnung sämtlicher für den Betrieb der Leuchte innerhalb eines Schaltschrankes nötiger Teile innerhalb des Gehäuses der Leuchte wird lediglich das Anschlusskabel noch aus dem Gehäuse herausgeführt und mit dem Stromnetz verbunden.

Insbesondere kann dabei besonders bevorzugt vorgesehen sein, dass in dem quaderförmigen Gehäuse ein Vorschaltgerät, ein Zündgerät und eine Zugentlastung für das Anschlusskabel angeordnet sind.

Auch kann besonders bevorzugt vorgesehen sein, dass ein Netzteil zur Speisung der Leuchtmittel vorgesehen ist, welches außerhalb des Gehäuses angeordnet ist.

Um eine besonders gleichmäßige Ausleuchtung des Schaltschrankes zu gewährleisten, kann besonders bevorzugt vorgesehen sein, dass mehrere Leuchten innerhalb eines Schaltschrankes vorgesehen und in Reihe zueinander geschaltet sind.

Dabei kann besonders bevorzugt vorgesehen sein, dass die Leuchten durch Steckverbindungen miteinander verbindbar sind, oder durch Schneidklemmtechnik, so dass keine vorkonfektionierten Leitungen mit Steckverbindern erforderlich sind.

Somit muss nur die erste innerhalb eines Schaltschrankes angeordnete Leuchte mit dem Stromnetz verbunden werden, und jede weitere Leuchte kann mittels Steckverbindungen mit der vorherigen Leuchte des Schaltschrankes verbunden werden und den benötigten Strom beziehen.

Um eine Zerstörung der Leuchte und eine damit eventuell verbundene Unfallgefahr zu vermeiden, kann besonders bevorzugt vorgesehen sein, dass die lichtdurchlässige

Abdeckung der Leuchte aus einem bruchsicheren Kunststoff, insbesondere aus Acrylglas, besteht.

Zudem kann besonders bevorzugt vorgesehen sein, dass innerhalb des Profilabschnitts ein weiteres Funktionselement angeordnet ist.

Dabei kann insbesondere bevorzugt vorgesehen sein, dass das weitere Funktionselement durch einen Bewegungsmelder gebildet ist, der mit der Leuchte gekoppelt ist.

Ein derartiger, als weiteres Funktionselement in die Leuchte integrierter Bewegungsmelder kann beispielsweise beim Öffnen der Schranktür die Beleuchtung des Schrankes aktivieren.

Ergänzend oder alternativ kann hierbei besonders bevorzugt vorgesehen sein, dass das weitere Funktionselement durch eine Steckdose gebildet ist.

Zudem kann besonders bevorzugt vorgesehen sein, dass die Zuleitung zu einer Leuchte und/oder die Verbindungsleitung zwischen zwei Leuchten im Hohlraum der Profilleiste angeordnet und beispielsweise durch eine Blindkappe abgedeckt ist.

Im Hohlraum des Profils kann die Zuleitung zu einer Leuchte oder die Verbindungsleitung zwischen zwei Leuchten verlegt werden, ohne weitere Geräte innerhalb des Schaltschrankes zu stören. Auch ist sie bei Abdeckung durch eine Blindkappe weitestgehend unsichtbar.

Um auch eine Blinkappe schnell und einfach und ohne den Einsatz von Werkzeugen an einem Profilabschnitt befestigen zu können, kann besonders bevorzugt vorgesehen sein, dass die Blindkappe mit an der Blindkappe ausgebildeten Haken oder Rastvorsprüngen in den Montagelochungen der Profilabschnitte befestigbar ist.

Auch zur Befestigung der Blindkappen werden lediglich die daran ausgebildeten Haken durch die Montagelochungen der Profilabschnitte hindurchgeführt, und entlang des Profils in eine Haltelage verschoben.

Weitergehend kann besonders bevorzugt vorgesehen sein, dass die Länge der Leuchte dem Höhenmaß der in Schaltschränken üblicherweise verwendeten Module entspricht.

Die Ausbildung der Länge der Leuchte entsprechende dem Höhenmaß der in Schaltschränken üblicherweise verwendeten Module ermöglicht ein passgenaues Einsetzen der Leuchte in Höhe der Modulreihen.

Schließlich kann besonders bevorzugt vorgesehen sein, dass das Gehäuse der Leuchte aus einem Abschnitt eines etwa L-förmigen Strangpressprofils gebildet ist, dessen einer Schenkel an seinem freien Ende eine Abwinkelung aufweist, an der eine mit ihrer Öffnung zum anderen Schenkel gerichtete Nut ausgebildet ist, wobei an dem anderen Schenkel oder im Übergangsbereich der beiden Schenkel eine weitere, zur ersten Nut parallele Nut ausgebildet ist, sodass in die Nuten Teile oder Stege, die an der Fassung, den elektrischen Bauteilen oder an weiteren Funktionsteilen ausgebildet sind, eingreifen oder einschiebbar sind.

Durch die Ausbildung derartiger Nuten können nahezu alle der in der Leuchte vorhandenen elektrischen Bauteile in die gegenüberliegenden Nuten eingeschoben, und in ihrer Montagesolllage gehaltert werden.

Ausführungsbeispiele der Erfindung sind in der Zeichnung dargestellt und im Folgenden näher beschrieben.

Es zeigt:
- Figur 1: das Profil eines erfindungsgemäßen Schaltschrankes mit daran befestigter Leuchte im Querschnitt gesehen;
- Figur 2: eine erfindungsgemäße Leuchte an einem Profil in der Montagesolllage;
- Figur 3: eine erfindungsgemäße Leuchte mit LED in Ansicht;
- Figur 4: eine erfindungsgemäße Leuchte mit Leuchtstoffröhre in Ansicht.

In den Figuren ist ein Teil eines Schaltschrankes, Geräteschrankes oder dergleichen Schrankes zur Aufnahme und Anordnung von elektrischen Bauteilen gezeigt. Dabei besteht ein Schaltschrank aus vertikalen und horizontalen metallischen Profilleisten 1 sowie an den Profilleisten 1 befestigten Verstrebungen, Wandteilen und dergleichen Stützteilen. Die Profilleisten 1 sind aus zwei zueinander parallel angeordneten, Montagelochungen aufweisenden Profilabschnitten 3,4 gebildet. Dabei weisen die Profilabschnitte 3,4 eine etwa rechteckige Querschnittsform auf. Die Profilabschnitte 3,4 sind über einen Steg 5 miteinander verbunden und schließen zwischen sich einen seitlich offenen Hohlraum ein. Auch ist in dem Schrank eine elektrische Leuchte 6 mit Leuchtengehäuse 7, Leuchtmittel und elektrischen Funktions- und Anschlussteilen befestigt.

Erfindungsgemäß ist die Leuchte 6, insbesondere deren Gehäuse 7, dem von den Profilabschnitten 3,4 gebildeten Hohlraum formmäßig angepasst. Dabei ist die Leuchte 6 in den Hohlraum eingesetzt und an den Montagelochungen 2 der Profilabschnitte 3,4 befestigt. Die den Hohlraum abschließende Vorderseite der Leuchte 6 weist eine lichtdurchlässige Abdeckung 13 auf.

Wie aus den Figuren ersichtlich, ist das Gehäuse 7 der Leuchte 6 im Querschnitt etwa dreieckig geformt. Dabei weist das Gehäuse 7 der Leuchte 6 zwei etwa rechtwinklig zueinander verlaufende Seitenflächen 8,9 auf. Diese liegen in der Montagesolllage an den Profilabschnitten 3,4 an. Hierdurch wird eine besonders Platz sparende und den Arbeitsraum des Schaltschrankes nicht störende Anordnung der Leuchte ermöglicht.

Das Gehäuse 7 der Leuchte 6 besteht erfindungsgemäß aus einem Wärme leitenden Material, im Ausführungsbeispiel aus Metall.

Hierdurch kann die in der Leuchte entstehende Wärme über das metallische Gehäuse der Leuchte an die Profilabschnitte des Schaltschrankes abgegeben und eine Überhitzung der Leuchte vermieden werden.

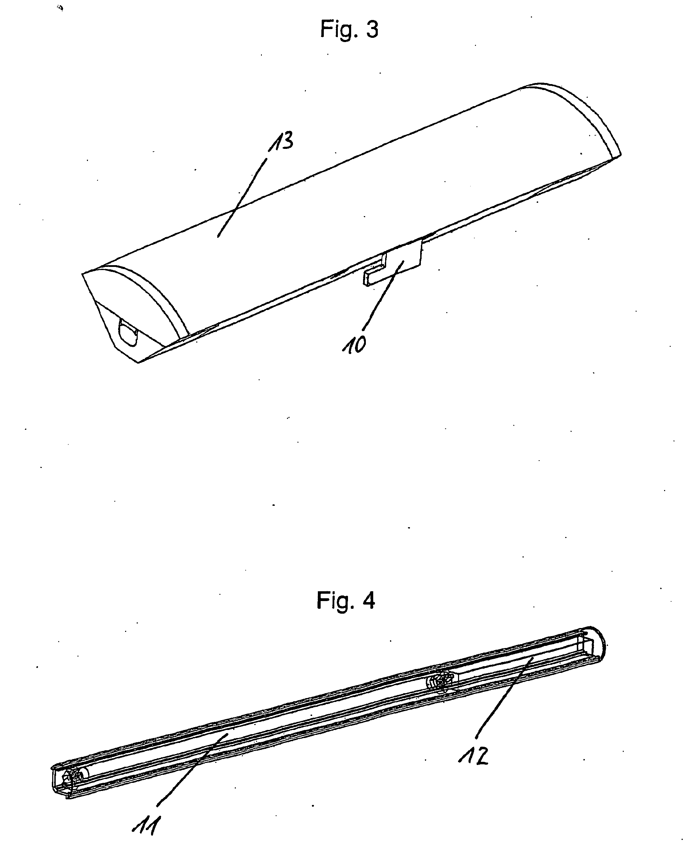

Wie insbesondere aus Figur 3 ersichtlich, sind am Gehäuse 7 der Leuchte 6 Mittel zur Befestigung der Leuchte 6 an den Profilabschnitten 3,4 ausgebildet. Im Ausführungsbeispiel ist das Mittel zur Befestigung der Leuchte 6 durch einen von der Seitenfläche des Gehäuses 7 abragenden Haken 10 gebildet. Ein derartiger Haken 10 kann in die in den Profilabschnitten 3,4, ausgebildeten Montagelochungen 2 eingesetzt und in eine Haltelage verschoben werden.

Alternativ und in den Figuren nicht gezeigt, können die Seitenflächen des Gehäuses 7 der Leuchte 6 Befestigungslochungen zum Durchführen von Schrauben aufweisen, mittels derer die Leuchte 6 an der Profilleiste 1 befestigbar ist.

Auch kann, wie aus den Figuren nicht ersichtlich, das Leuchtmittel der Leuchte 6 durch eine oder mehrere in Längsrichtung der Leuchte 6 verteilt angeordnete LEDs gebildet sein. Dabei ist zwischen den LEDs und dem Gehäuseboden je eine Reflektionsfläche angeordnet. Die den längsseitigen Gehäuseenden nahen Reflektionsflächen sind nahe den Enden des Gehäuses 7 beginnend in einem spitzen Winkel zum Boden des Gehäuses 7 angeordnet, um eine breite Streuung des austretenden Lichtes zu ermöglichen.

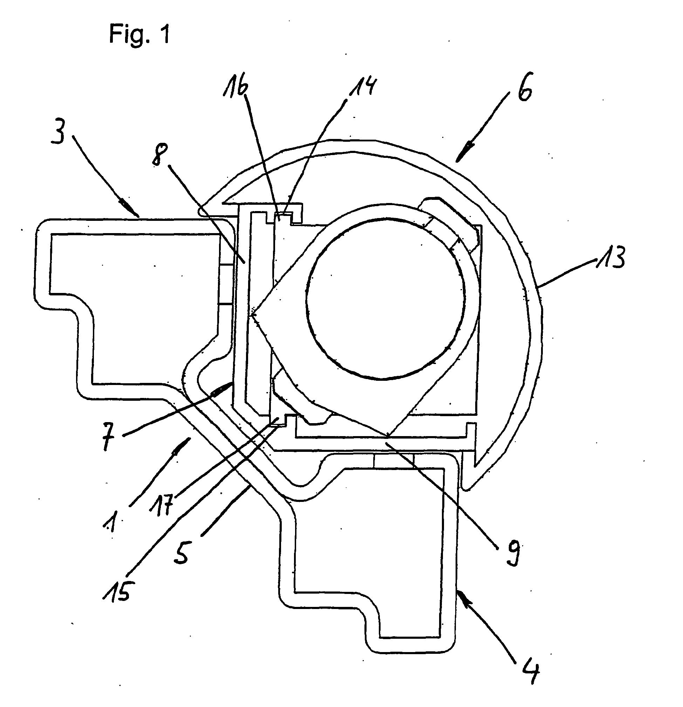

Wie insbesondere aus den Figuren 1 und 4 ersichtlich, ist das Leuchtmittel der Leuchte 6 im Ausführungsbeispiel durch eine in dem Gehäuse 7 längs angeordnete Leuchtstoffröhre 11 gebildet. Die Leuchtstoffröhre 11 ist dabei durch eine T2 oder T5 Leuchtstoffröhre gebildet.

Wie insbesondere aus Figur 4 ersichtlich, sind die Elektronikbauteile für die Leuchtstoffröhre 11 in einem quaderförmigen Gehäuse 12 angeordnet, welches im Gehäuse 7 in Längsrichtung anschleißend an die Leuchtstoffröhre 11 angeordnet ist. Dabei ist im Ausführungsbeispiel in dem quaderförmigen Gehäuse 12 ein Vorschaltgerät, ein Zündgerät und eine Zugentlastung für das Anschlusskabel angeordnet.

Auch kann, wie aus den Figuren nicht ersichtlich, ein Netzteil zur Speisung der Leuchtmittel vorgesehen sein, welches außerhalb des Gehäuses 7 angeordnet ist.

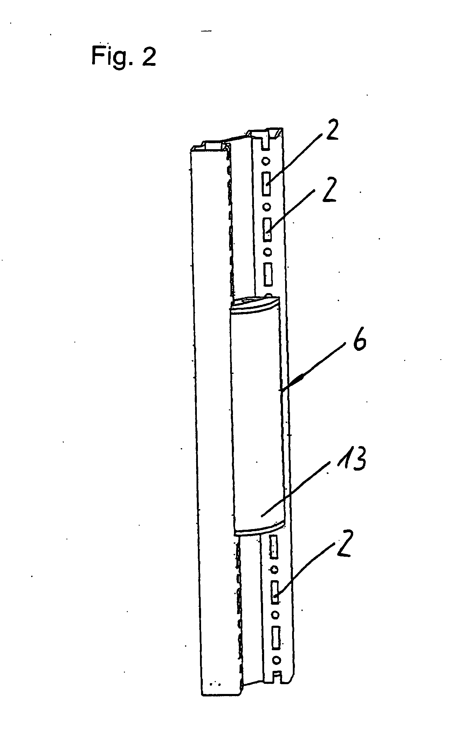

Innerhalb eines Schaltschrankes können mehrere Leuchten 6 vorgesehen und in Reihe zueinander geschaltet sein. Dabei sind die Leuchten 6 durch Steckverbindungen oder Schneidklemmtechnik miteinander verbindbar. Die insbesondere aus den Figuren 1 bis 3 ersichtliche lichtdurchlässige Abdeckung 13 der Leuchte besteht im Ausführungsbeispiel aus bruchsicherem Acrylglas, um eine Unfallgefahr durch beispielsweise zerbrochenes Glas auszuschließen.

Wie insbesondere aus Figur 1 ersichtlich, ist das Gehäuse 7 der Leuchte 6 aus einem Abschnitt eines etwa L-förmigen Strangpressprofils gebildet. Dabei weist der eine Schenkel des etwa L-förmigen Strangpressprofils an seinem freien Ende eine Abwinkelung auf, an der eine mit ihrer Öffnung zum anderen Schenkel gerichtete Nut 14 ausgebildet ist. Im Übergangsbereich der beiden Schenkel ist eine weitere, zur ersten Nut 14 parallele Nut 15 ausgebildet. In die Nuten 14,15 greifen Stege 16,17, die im Ausführungsbeispiel an der Fassung ausgebildet sind, ein und sind in diese einschiebbar.

Die Erfindung ist nicht auf das Ausführungsbeispiel beschränkt, sondern im Rahmen der Offenbarung vielfach variabel.

Alle neuen, in der Beschreibung und/oder Zeichnung offenbarten Einzel- und Kombinationsmerkmale werden als erfindungswesentlich angesehen.

## Patentansprüche

1. Schaltschrank, Geräteschrank oder dergleichen Schrank zur Aufnahme und Anordnung von elektronischen Bauteilen, wobei der Schaltschrank aus vertikalen und horizontalen metallischen Profilleisten (1) sowie an den Profilleisten (1) befestigten Verstrebungen, Wandteilen und dergleichen Stützteilen besteht, die Profilleisten (1) aus zwei zueinander parallel angeordneten, Montagelochungen (2) aufweisenden Profilabschnitten (3,4) etwa rechteckiger Querschnittsform bestehen, die über einen Steg (5) verbunden sind und zwischen sich einen seitlich offenen Hohlraum einschließen, und wobei in dem Schrank eine elektrische Leuchte (6) mit Leuchtengehäuse (7), Leuchtmittel und elektrischen Funktions- und Anschlussteilen befestigt ist, **dadurch gekennzeichnet, dass** das Gehäuse (7) der Leuchte (6), dem von den Profilabschnitten (3,4) gebildeten Hohlraum formmäßig angepasst ist, in den Hohlraum eingesetzt ist und an den Profilabschnitten (3,4) befestigt ist, dass die den Hohlraum abschließende Vorderseite der Leuchte (6) eine lichtdurchlässige Abdeckung (13) aufweist, dass das Gehäuse (7) der Leuchte (6) im Querschnitt etwa dreieckig oder trapezförmig ist und zwei etwa rechtwinklig zueinander verlaufende Seitenflächen (8,9) aufweist, die in der Montagesolllage an den Profilabschnitten (3,4) anliegen und **dass** das Gehäuse (7) der Leuchte (6) aus einem Wärme leitenden Material besteht.

2. Schaltschrank mit Leuchte nach Anspruch 1, **dadurch gekennzeichnet, dass** am Gehäuse (7) der Leuchte (6) Mittel zur Befestigung der Leuchte (6) an den Profilabschnitten (3,4) ausgebildet sind.

3. Schaltschrank mit Leuchte nach Anspruch 2, **dadurch gekennzeichnet, dass** die Mittel zur Befestigung der Leuchte (6) durch einen oder mehrere von den Seitenflächen des Gehäuses (7) abragenden Haken (10) oder Rastnasen gebildet sind, die in in den Profilabschnitten (3,4) ausgebildete Montagelochungen (2), beispielsweise in Langlöcher, einsetzbar und in eine Haltelage verschiebbar sind, oder dass die Leuchte (6) mittels Magneten an mindestens einem Profilabschnitt (3,4) befestigbar ist.

4. Schaltschrank mit Leuchte nach Anspruch 1, **dadurch gekennzeichnet, dass** die Seitenflächen des Gehäuses (7) der Leuchte (6) Befestigungslochungen zum Durchführen von Schrauben aufweisen, mittels derer die Leuchte (6) an der Profilleiste (1) befestigbar ist.

5. Schaltschrank mit Leuchte nach einem der Ansprüche 1 bis 4, **dadurch gekennzeichnet, dass** das Leuchtmittel der Leuchte (6) durch mindestens eine, vorzugsweise durch mehrere in Längsrichtung der Leuchte (6) verteilt angeordnete, LEDs gebildet ist.

6. Schaltschrank mit Leuchte nach Anspruch 5, **dadurch gekennzeichnet, dass** zwischen den LEDs und dem Gehäuseboden je eine Reflektionsfläche angeordnet ist.

7. Schaltschrank mit Leuchte nach Anspruch 6, **dadurch gekennzeichnet, dass** die den längsseitigen Gehäuseenden nahen Reflektionsflächen nahe den Enden des Gehäuses (7) beginnend in einem spitzen Winkel zum Boden des Gehäuses (7) angeordnet sind.

8. Schaltschrank mit Leuchte nach einem der Ansprüche 1 bis 3, **dadurch gekennzeichnet, dass** das Leuchtmittel der Leuchte (6) durch eine in dem Gehäuse (7) längs angeordnete Leuchtstoffröhre (11) gebildet ist.

9. Schaltschrank mit Leuchte nach Anspruch 8, **dadurch gekennzeichnet, dass** als Leuchtstoffröhre (11) eine T2 Leuchtstoffröhre (11) vorgesehen ist.

10. Schaltschrank mit Leuchte nach einem der Ansprüche 8 oder 9, **dadurch gekennzeichnet, dass** Elektronikbauteile für die Leuchtstoffröhre (11) in einem quaderförmigen Gehäuse (12) angeordnet sind, welches im Gehäuse in Längsrichtung anschließend an die Leuchtstoffröhre (11) oder unter der Leuchtstoffröhre (11) angeordnet ist.

11. Schaltschrank mit Leuchte nach Anspruch 10, **dadurch gekennzeichnet, dass** in dem quaderförmigen Gehäuse (12) ein Vorschaltgerät, ein Zündgerät und eine Zugentlastung für das Anschlusskabel angeordnet sind.

12. Schaltschrank mit Leuchte nach Anspruch 1 bis 5, **dadurch gekennzeichnet, dass** ein Netzteil zur Speisung der Leuchtmittel vorgesehen ist, welches außerhalb des Gehäuses (7) angeordnet ist.

13. Schaltschrank mit Leuchte nach einem der Ansprüche 1 bis 12, **dadurch gekennzeichnet, dass** mehrere Leuchten (6) innerhalb eines Schaltschrankes vorgesehen und in Reihe zueinander geschaltet sind.

14. Schaltschrank mit Leuchte nach Anspruch 13, **dadurch gekennzeichnet, dass** die Leuchten (6) durch Steckverbindungen miteinander verbindbar sind.

15. Schaltschrank mit Leuchte nach einem der Ansprüche 1 bis 14, **dadurch gekennzeichnet, dass** die lichtdurchlässige Abdeckung (13) der Leuchte (6) aus einem bruchsicheren Kunststoff, insbesondere aus Acrylglas, besteht.

16. Schaltschrank mit Leuchte nach einem der Ansprüche 1 bis 15, **dadurch gekennzeichnet, dass** innerhalb des Profilabschnitts (3,4) ein weiteres Funktionselement angeordnet ist.

17. Schaltschrank mit Leuchte nach Anspruch 16, **dadurch gekennzeichnet, dass** das weitere Funktionselement durch einen Bewegungsmelder gebildet ist, der mit der Leuchte (6) gekoppelt ist.

18. Schaltschrank mit Leuchte nach Anspruch 16, **dadurch gekennzeichnet, dass** das weitere Funktionselement durch eine Steckdose gebildet ist.

19. Schaltschrank mit Leuchte nach einem der Ansprüche 1 bis 18, **dadurch gekennzeichnet, dass** die Zuleitung zu einer Leuchte (6) und/oder die Verbindungsleitung zwischen zwei Leuchten (6) im Hohlraum der Profilleiste (1) angeordnet und beispielsweise durch eine Blindkappe abgedeckt ist.

20. Schaltschrank mit Leuchte nach Anspruch 19, **dadurch gekennzeichnet, dass** die Blindkappe mit an der Blindkappe ausgebildeten Haken oder Rastvorsprüngen in den Montagelochungen (2) der Profilabschnitte (3,4) befestigbar ist.

21. Schaltschrank mit Leuchte nach einem der Ansprüche 1 bis 20, **dadurch gekennzeichnet, dass** die Länge der Leuchte (6) dem Höhenmaß der in Schaltschränken üblicherweise verwendeten Module entspricht.

22. Schaltschrank mit Leuchte nach einem der Ansprüche 1 bis 21, **dadurch gekennzeichnet, dass** das Gehäuse (7) der Leuchte (6) aus einem Abschnitt eines etwa L-förmigen Strangpressprofils gebildet ist, dessen einer Schenkel an seinem freien Ende eine Abwinkelung aufweist, an der eine mit ihrer Öffnung zum anderen Schenkel gerichtete Nut (14) ausgebildet ist, wobei an dem anderen Schenkel oder im Übergangsbereich der beiden Schenkel eine weitere, zur ersten Nut (14) parallele Nut (15) ausgebildet ist, sodass in die Nuten (14,15) Teile oder Stege (16,17), die an der Fassung, den elektrischen Bauteilen oder an weiteren Funktionsteilen ausgebildet sind, eingreifen oder einschiebbar sind.

## Claims

1. Switch cabinet, equipment cabinet or other such cabinet for accommodating and arranging electronic components, wherein the switch cabinet consists of vertical and horizontal metal profile strips (1) and also struts, wall parts and other such support parts which are fixed to the profile strips, wherein the profile strips (1) consist of two profile sections (3, 4) of approximately rectangular cross-sectional shape which are arranged parallel to one another, have mounting holes (2), are connected via a web (5) and enclose between them a hollow space which is open at the side, and wherein an electric light (6) comprising a light housing (7), lighting means and electrical functional and connection parts is fixed in the cabinet, **characterised in that** the housing (7) of the light (6), which is adapted in terms of its shape to the hollow space formed by the profile sections (3, 4), is inserted in the hollow space and is fixed to the profile sections (3, 4), **in that** the front side of the light (6) which closes the hollow space has a light-permeable cover (13), **in that** the housing (7) of the light (6) is approximately triangular or trapezoidal in cross section and has two side faces (8, 9) which run approximately at right angles to one another and in the desired mounted position bear against the profile sections (3, 4), and **in that** the housing (7) of the light (6) is made of a heat-conducting material.

2. Switch cabinet with a light according to claim 1, **characterised in that** means for fixing the light (6) to the profile sections (3, 4) are formed on the housing (7) of the light (6).

3. Switch cabinet with a light according to claim 2, **characterised in that** the means for fixing the light (6) are formed by one or more hooks (10) or latching protrusions which project from the side faces of the housing (7) and which can be inserted in mounting holes (2), for example in elongate holes, formed in the profile sections (3, 4) and can be displaced into a holding position, or **in that** the light (6) can be fixed to at least one profile section (3, 4) by means of magnets.

4. Switch cabinet with a light according to claim 1, **characterised in that** the side faces of the housing (7) of the light (6) have fixing holes for the penetration of screws, by means of which the light (6) can be fixed to the profile strip (1).

5. Switch cabinet with a light according to one of claims 1 to 4, **characterised in that** the lighting means of the light (6) is formed by at least one, preferably a plurality of LEDs distributed in the longitudinal direction of the light (6).

6. Switch cabinet with a light according to claim 5, **characterised in that** in each case a reflection surface is arranged between the LEDs and the housing bottom.

7. Switch cabinet with a light according to claim 6, **characterised in that** the reflection surfaces close to the longitudinal side ends of the housing are arranged close to the ends of the housing (7) starting at an acute angle relative to the bottom of the housing (7).

8. Switch cabinet with a light according to one of claims 1 to 3, **characterised in that** the lighting means of the light (6) is formed by a fluorescent tube (11) arranged longitudinally in the housing (7).

9. Switch cabinet with a light according to claim 8, **characterised in that** a T2 fluorescent tube (11) is provided as the fluorescent tube (11).

10. Switch cabinet with a light according to one of claims 8 or 9, **characterised in that** electronic components for the fluorescent tube (11) are arranged in a block-shaped housing (12) which is arranged in the housing in the longitudinal direction next to the fluorescent tube (11) or below the fluorescent tube (11).

11. Switch cabinet with a light according to claim 10, **characterised in that** a ballast, an ignition device and a strain relief means for the connection cable are arranged in the block-shaped housing (12).

12. Switch cabinet with a light according to claims 1 to 5, **characterised in that** a power supply unit for supplying the lighting means is provided, which power supply unit is arranged outside the housing (7).

13. Switch cabinet with a light according to one of claims 1 to 12, **characterised in that** a plurality of lights (6) are provided within a switch cabinet and are connected in series with one another.

14. Switch cabinet with a light according to claim 13, **characterised in that** the lights (6) can be connected to one another by plug-in connections.

15. Switch cabinet with a light according to one of claims 1 to 14, **characterised in that** the light-permeable cover (13) of the light (6) is made of a shatterproof plastic, in particular acrylic glass.

16. Switch cabinet with a light according to one of claims 1 to 15, **characterised in that** a further functional element is arranged within the profile section (3, 4).

17. Switch cabinet with a light according to claim 16, **characterised in that** the further functional element is formed by a motion detector which is coupled to the light (6) .

18. Switch cabinet with a light according to claim 16, **characterised in that** the further functional element is formed by a plug socket.

19. Switch cabinet with a light according to one of claims 1 to 18, **characterised in that** the supply line to a light (6) and/or the connecting line between two lights (6) is arranged in the hollow space of the profile strip (1) and is covered for example by a cap.

20. Switch cabinet with a light according to claim 19, **characterised in that** the cap can be fixed in the mounting holes (2) of the profile sections (3, 4) by means of hooks or latching protrusions formed on the cap.

21. Switch cabinet with a light according to one of claims 1 to 20, **characterised in that** the length of the light (6) corresponds to the height dimension of the modules usually used in switch cabinets.

22. Switch cabinet with a light according to one of claims 1 to 21, **characterised in that** the housing (7) of the light (6) is formed of a section of an approximately L-shaped extruded profile, one leg of which has at its free end an angled portion on which a groove (14) directed with its opening towards the other leg is formed, wherein a further groove (15) parallel to the first groove (14) is formed on the other leg or in the transition region of the two legs, so that parts or webs (16, 17) which are formed on the holder, the electrical components or on further functional parts can engage in or be pushed into the grooves (14, 15).

## Revendications

1. Armoire de distribution, armoire d'appareillage ou armoire analogue destinée à recevoir et organiser des composants électroniques, l'armoire de distribution étant constituée de baguettes profilées métalliques verticales et horizontales (1) ainsi que d'entretoises, parties de paroi et éléments de support analogues fixés au niveau ou sur les baguettes profilées (1), les baguettes profilées (1) étant constituées de deux segments profilés (3, 4) de section approximativement rectangulaire, disposés parallèlement l'un à l'autre et présentant des perforations de montage (2), qui sont reliés par une branche (5) et incluent entre eux une cavité ouverte sur le côté, et un luminaire électrique (6) avec boîtier de luminaire (7), des moyens lumineux et pièces de fonction et de raccordement électrique étant fixés dans l'armoire, **caractérisée en ce que** le boîtier (7) du luminaire (6) est adapté quant à sa forme à la cavité formée par les segments profilés (3, 4), mis en place dans la cavité et fixé au segments profilés (3, 4), que la face avant du luminaire (6) qui ferme la cavité comporte un élément de recouvrement (13) translucide, que le boîtier (7) du luminaire (6) est approximativement triangulaire ou trapézoïdal en section transversale et présente deux faces latérales (8, 9) s'étendant approximativement à angle droit l'une par rapport à l'autre qui, dans la position de montage nominale, reposent sur les segments profilés (3, 4) et que le boîtier (7) du luminaire (6) est constitué d'un ou réalisé en un matériau conducteur de la chaleur.

2. Armoire de distribution avec luminaire selon la revendication 1, **caractérisée en ce que** des moyens pour fixer le luminaire (6) aux segments profilés (3, 4) sont formés sur le boîtier (7) du luminaire (6).

3. Armoire de distribution avec luminaire selon la revendication 2, **caractérisée en ce que** les moyens pour fixer le luminaire (6) sont formés par un ou plusieurs crochets (10) ou ergots d'encliquetage faisant saillie des faces latérales du boîtier (7), qui peuvent être insérés dans des perforations de montage (2) formées dans les segments profilés (3, 4), par exemple dans des trous oblongs, et déplacés dans une position de fixation, ou que le luminaire (6) peut être fixé à au moins un segment profilé (3, 4) au moyen d'aimants.

4. Armoire de distribution avec luminaire selon la revendication 1, **caractérisée en ce que** les faces latérales du boîtier (7) du luminaire (6) présentent des perforations de fixation pour le passage de vis au moyen desquelles le luminaire (6) peut être fixé à la baguette profilée (1).

5. Armoire de distribution avec luminaire selon l'une des revendications 1 à 4, **caractérisée en ce que** le moyen lumineux du luminaire (6) est formé par au moins une, de préférence plusieurs LED réparties en direction longitudinale du luminaire (6).

6. Armoire de distribution avec luminaire selon la revendication 5, **caractérisée en ce qu'**une surface réfléchissante est disposée entre chaque LED et le fond du boîtier.

7. Armoire de distribution avec luminaire selon la revendication 6, **caractérisée en ce que** les surfaces réfléchissantes proches des extrémités longitudinales du boîtier qui commencent près des extrémités du boîtier (7) sont disposées à angle aigu par rapport au fond du boîtier (7).

8. Armoire de distribution avec luminaire selon l'une des revendications 1 à 3, **caractérisé en ce que** le moyen lumineux du luminaire (6) est formé par un tube fluorescent (11) disposé longitudinalement dans le boîtier (7).

9. Armoire de distribution avec luminaire selon la revendication 8, **caractérisée en ce qu'**un tube fluorescent T2 (11) est prévu comme tube fluorescent (11).

10. Armoire de distribution avec luminaire selon l'une des revendications 8 ou 9, **caractérisée en ce que** les composants électroniques pour le tube fluorescent (11) sont disposés dans un boîtier parallélépipédique (12) qui est disposé dans le boîtier à la suite du tube fluorescent (11) en direction longitudinale ou sous le tube fluorescent (11).

11. Armoire de distribution avec luminaire selon la revendication 10, **caractérisée en ce qu'**un ballast, un starter ou dispositif d'allumage et un dispositif de décharge de traction pour le câble de raccordement sont disposés dans le boîtier parallélépipédique (12).

12. Armoire de distribution avec luminaire selon l'une des revendications 1 à 5, **caractérisée en ce qu'**il est prévu une unité d'alimentation pour alimenter les moyens lumineux, laquelle est disposée en dehors ou à l'extérieur du boîtier (7).

13. Armoire de distribution avec luminaire selon l'une des revendications 1 à 12, **caractérisée en ce que** plusieurs luminaires (6) sont prévus à l'intérieur d'une armoire de distribution et couplés en série les uns avec les autres.

14. Armoire de distribution avec luminaire selon la revendication 13, **caractérisée en ce que** les luminaires (6) peuvent être connectés les uns aux autres par des connexions enfichables.

15. Armoire de distribution avec luminaire selon l'une des revendications 1 à 14, **caractérisée en ce que** l'élément de recouvrement translucide (13) du luminaire (6) est réalisé dans une matière plastique incassable, en particulier en verre acrylique.

16. Armoire de distribution avec luminaire selon l'une des revendications 1 à 15, **caractérisée en ce qu'**un élément de fonction supplémentaire est disposé à l'intérieur du segment profilé (3, 4).

17. Armoire de distribution avec luminaire selon la revendication 16, **caractérisée en ce que** l'élément de fonction supplémentaire est formé par un détecteur de mouvement qui est couplé au luminaire (6).

18. Armoire de distribution avec luminaire selon la revendication 16, **caractérisée en ce que** l'élément de fonction supplémentaire est formé par une prise de courant.

19. Armoire de distribution avec luminaire selon l'une des revendications 1 à 18, **caractérisée en ce que** la ligne d'alimentation d'un luminaire (6) et/ou la ligne de connexion entre deux luminaires (6) est disposée dans la cavité de la baguette profilée (1) et recouverte, par exemple, par un cache.

20. Armoire de distribution avec luminaire selon la revendication 19, **caractérisée en ce que** le cache peut être fixé dans les perforations de montage (2) des segments profilés (3, 4) au moyen de crochets ou de saillies d'encliquetage formés sur le cache.

21. Armoire de distribution avec luminaire selon l'une des revendications 1 à 20, **caractérisée en ce que** la longueur du luminaire (6) correspond à la hauteur des modules habituellement utilisés dans les armoires de distribution.

22. Armoire de distribution avec luminaire selon l'une des revendications 1 à 21, **caractérisée en ce que** le boîtier (7) du luminaire (6) est formé à partir d'un segment d'un profilé extrudé approximativement en forme de L, dont une branche présente à son extrémité libre un coudage sur lequel est formée une rainure (14) dont l'ouverture est dirigée vers l'autre branche, une autre rainure (15) parallèle à la première rainure (14) étant formée sur l'autre branche ou dans la zone de jonction des deux branches, de sorte que des pièces ou nervures (16, 17) qui sont formées sur la douille, sur les composants électriques ou sur d'autres pièces de fonction s'engagent ou puissent être insérées dans les rainures (14, 15).
